# EUROPEAN PATENT SPECIFICATION

(11) **EP 3 869 929 B1**
(45) Date of publication and mention of the grant of the patent: **09.11.2022**
(21) Application number: 21164188.1
(22) Date of filing: 23.03.2021
(51) Int. Cl.: H05K 7/20

(54) **REFRIGERATING SYSTEM**
KÜHLSYSTEM
SYSTÈME DE RÉFRIGÉRATION

(30) Priority: 11.06.2020 CN 202010531346; 11.06.2020 CN 202021076966 U
(43) Date of publication of application: 25.08.2021
(73) Proprietor: BEIJING BAIDU NETCOM SCIENCE AND TECHNOLOGY CO. LTD., 100085 Beijing (CN)
(72) Inventor: LUO, Zhiming, BEIJING, 100085 (CN); DUAN, Yiyi, BEIJING, 100085 (CN); YI, Bin, BEIJING, 100085 (CN); LI, Xiaozhong, BEIJING, 100085 (CN)
(74) Representative: Brevalex

(56) References cited:
- EP-B1- 2 681 980
- CN-A- 108 954 883
- CN-A- 110 567 199
- US-B2- 8 286 442

## Description

### TECHNICAL FIELD

The present application relates to the technical field of heat exchange, in particular to the technical field of cooling for data centers that may be used for applications (including but not limited to) such as cloud computing, cloud storage, big data computing, deep learning and image processing.

### BACKGROUND

With the development of internet technology, cooling requirements for data centers that may be used for applications (including but not limited to) such as cloud computing, cloud storage, big data computing, deep learning and image processing have become higher and higher in recent years.

(CN110567199A) discloses an evaporation cooling type compression condensing device with natural cooling. The evaporation cooling type compression condensing device comprises a main engine room, wherein the main engine room is hermetically isolated from a spray evaporation cooling cabin; and the spray evaporation cooling cabin communicates with an exhaust cabin; a compression condensation refrigeration system correspondingly connected with an evaporation condenser in the spray evaporation cooling cabin is arranged in the main engine room; a spray distributor is arranged above the evaporation condenser; a natural cooling fin heat exchanger is arranged on the inner side of a top air inlet of the spray evaporation cooling cabin or the airinlet side of an exhaust fan of the exhaust cabin; and the natural cooling fin heat exchanger is connected with a natural cooling liquid storage/heat exchanger through a refrigerant circulating pipeline. According to the device, a refrigerant is used as a cold (heat) carrier, the working efficiency is high, the energy consumption is low, and the safety is high.

(CN108954883A) provides an energy-saving type cooling machine. By means of the energy-saving type cooling machine, the technical problem that existing cooling machines cannot meet the energy-saving requirement can be solved. The energy-saving type cooling machine comprises a refrigerating system and a liquid circulation loop. The refrigerating system comprises an evaporative condenser. The energy-saving type cooling machine is characterized in that a liquid input pipe is sequentially provided with a liquid temperature probe, a circulating pump and a first electric valve in the liquid flow direction; the cooling machine further comprises a second condenser coil pipe, a liquid bypass loop and an environment temperature probe; the second condenser coil pipe is arranged to be opposite to a first condenser coil pipe of the evaporative condenser and located between a spray pipe and a water pan of the evaporative condenser; the liquid bypass loop comprises a liquid input branch pipe and a liquid backflow branch pipe; the liquid input branch pipe connects the input end of the second condenser coil pipe with the position, located between the first electric valve and the circulating pump, of the liquid input pipe; the liquid backflow branch pipe is provided with a second electric valve and connects the output end of a second condenser with the position located between an evaporator and the first electric valve.

(EP2681980B1) relates to a cooling device, in particular an air-conditioning unit for an electrical device, in particular a computer system, wherein the electrical device, in particular the computer system, is housed in a closed or enclosed space, and the cooling device comprises at least one evaporator, preferably a lateral wall evaporator, one compressor and one condenser. The cooling device is characterised in that the compressor and the condenser are arranged outside the closed or enclosed space, preferably in an external unit, and the evaporator is arranged inside the closed space, wherein the evaporator is designed in a redundant configuration in a single housing.

(US8286442B2) elates to a system for providing cooled air to electronic equipment including a data center having electronic equipment in operation, a plurality of on-floor cooling units, and a cooling water source. The on-floor cooling units cool air warmed by the electronic equipment. The cooling water source is configured to supply cooling water that reduces a temperature of the on-floor cooling units. The power usage effectiveness ("PUE") of the system is less than 1.3, wherein the PUE is defined by energy used to operate the data center divided by energy used to run the electronic equipment.

### SUMMARY

The present application provides a refrigeration system.

The refrigeration system of the present application includes:
an indoor heat exchange module configured for refrigerant to absorb heat; and
outdoor heat exchange modules configured for the refrigerant to dissipate heat; and the outdoor heat exchange module including a compression device, an evaporative condenser and a liquid supplement device; and
wherein the outdoor heat exchange modules are switchable between a standby mode and an active mode; in the standby mode, the outdoor heat exchange module is disconnected from the indoor heat exchange module; when the outdoor heat exchange module is switched to the active mode, the outdoor heat exchange module is connected to the indoor heat exchange module, the compression device starts up, and the liquid supplement device supplies cooling liquid to the evaporative condenser during an startup process of the compression device;
wherein when the outdoor heat exchange module is in the active mode, the compression device is used to compress a low-temperature and low-pressure gaseous refrigerant output from the indoor heat exchange module into a high-temperature and high-pressure gaseous refrigerant; the high-temperature and high-pressure gaseous refrigerant is condensed in the evaporative condenser to convert the refrigerant from a gas state to a liquid state; and then the liquid refrigerant flows back to an input terminal of the indoor heat exchange module, and the refrigerant absorbs heat in the indoor heat exchange module and is converted from the liquid state to the gas state, and flows back to the compression device;
wherein the liquid supplement device includes:
a liquid storage tank configured to store cooling liquid; and
a refrigeration device configured to provide cooling energy to the cooling liquid in the liquid storage tank; wherein when the outdoor heat exchange module is in the standby mode, the refrigeration device operates to maintain the cooling liquid in the liquid storage tank within a preset temperature range.

In an embodiment, the evaporative condenser includes:
a condensing coil, an input terminal of the condensing coil being connected to an output terminal of the compression device, and an output terminal of the condensing coil being connected to an input terminal of the indoor heat exchange module;
a spray device configured to spray cooling liquid to the condensing coil, so that the refrigerant in the condensing coil is converted from a liquid state to a gas state; and
a liquid collecting tray configured to collect the cooling liquid output from the spray device; and
wherein when the outdoor heat exchange module is switched to the active mode, during the startup process of the compression device, the spray device is supplied with the cooling liquid from the liquid supplement device; and after the compression device starts up normally, the spray device is supplied with the cooling liquid from the liquid collecting tray through a spray pump.

In an embodiment, the compression device includes an oil-free compressor; and the oil-free compressor is connected between an output terminal of the indoor heat exchange module and an input terminal of the evaporative condenser.

In an embodiment, the compression device further includes a direct flow pipeline connected in parallel with the oil-free compressor; and the direct flow pipeline is connected between the output terminal of the indoor heat exchange module and the input terminal of the evaporative condenser; and
when the outdoor heat exchange module is switched to the active mode, during the startup process of the compression device, the refrigerant is delivered from the output terminal of the indoor heat exchange module to the input terminal of the evaporative condenser through the direct flow pipeline.

In an embodiment, the oil-free compressor is a magnetic suspension compressor.

In an embodiment, the outdoor heat exchange module further includes a liquid storage portion; and the liquid storage portion is connected between an output terminal of the evaporative condenser and an input terminal of the indoor heat exchange module, and is configured to store the refrigerant output from the evaporative condenser; and
the oil-free compressor is an air suspension compressor; the compression device further includes an air supply pipeline; and the air supply pipeline is connected to an output terminal of the liquid storage portion and an input terminal of the air suspension compressor; and wherein when the outdoor heat exchange module is in the standby mode, the air supply pipeline converts the refrigerant output from the liquid storage portion from a liquid state to a gas state, and delivers the refrigerant to the input terminal of the air suspension compressor.

In an embodiment, the air supply pipeline includes a liquid supplement pump and a gas conversion portion; the liquid supplement pump is connected to the output terminal of the liquid storage portion and is configured to pump the refrigerant in the liquid storage portion to the gas conversion portion; and the gas conversion portion is connected to the input terminal of the gas suspension compressor, and is configured to convert the refrigerant from a liquid state to a gas state.

In an embodiment, the refrigeration system further includes:
a refrigerant delivery pipe network, which is connected between the outdoor heat exchange module and the indoor heat exchange module and is configured to deliver the refrigerant between the outdoor heat exchange module and the indoor heat exchange module.

In an embodiment, the refrigerant delivery pipe network includes a first delivery pipe network and a second delivery pipe network; an output terminal of the outdoor heat exchange module is connected with an input terminal of the indoor heat exchange module through the first delivery pipe network; and an output terminal of the indoor heat exchange module is connected with an input terminal of the outdoor heat exchange module through the second delivery pipe network.

In an embodiment, the outdoor heat exchange module further includes a third on-off valve and a fourth on-off valve; the third on-off valve is provided between the output terminal of the outdoor heat exchange module and the first delivery pipe network; and the fourth on-off valve is provided between the input terminal of the outdoor heat exchange module and the second delivery pipe network;
wherein when the outdoor heat exchange module is in the active mode, the third on-off valve and the fourth on-off valve are both tuned on; and when the outdoor heat exchange module is in the standby mode, the third on-off valve and the fourth on-off valves are both turned off.

In an embodiment, the indoor heat exchange module includes a plurality of plate heat exchangers; input terminals of the plurality of plate heat exchangers are connected in parallel to the first delivery pipe network; and output terminals of the plurality of plate heat exchangers are connected in parallel to the second delivery pipe network.

In an embodiment, the number of outdoor heat exchange modules is greater than the number of indoor heat exchange modules; among the outdoor heat exchange modules, the number of outdoor heat exchange modules in the active mode is M, and the number of outdoor heat exchange modules in the standby mode is N;
wherein, when M<6, N=1; when M ≥ 6, N=2.

It should be understood that the contents in this section are not intended to identify the key or critical features of the embodiments of the present application, and are not intended to limit the scope of the present application. Other features of the present application will become readily apparent from the following description.

### BRIEF DESCRIPTION OF THE DRAWINGS

With reference to the drawings and the following detailed description, the foregoing and other features, advantages and aspects of the embodiments of the present application will become more apparent. In the drawings, the same or similar reference sign represents the same or similar element. Wherein:
FIG. 1 is a schematic structural diagram of a refrigeration system according to an embodiment of the present application;
FIG. 2 is a schematic structural diagram of an evaporative condenser of a refrigeration system according to an embodiment of the present application;
FIG. 3 is a schematic structural diagram of an evaporative condenser of a refrigeration system according to an embodiment of the present application;
FIG. 4 is a schematic structural diagram of a liquid supplement device of a refrigeration system according to an embodiment of the present application;
FIG. 5 is a schematic structural diagram of a compression device of a refrigeration system according to an embodiment of the present application;
FIG. 6 is a schematic structural diagram of a compression device of a refrigeration system according to another embodiment of the present application;
FIG. 7 is a schematic structural diagram of an indoor heat exchange module of a refrigeration system according to an embodiment of the present application.

### DETAILED DESCRIPTION

The exemplary embodiments of the present application are described below with reference to the accompanying drawings, which include various details of the embodiments of the present application to facilitate understanding, and should be considered as merely exemplary. Also, descriptions of well-known functions and structures are omitted from the following description for clarity and conciseness.

In related art, a cooling scheme of the data center mostly adopts the conventional chilled water data center design scheme, but an overall energy saving effect is poor; while a large phase change system with better energy saving effect has defects such as poor stability and inability to meet continuous cooling requirements of the data center.

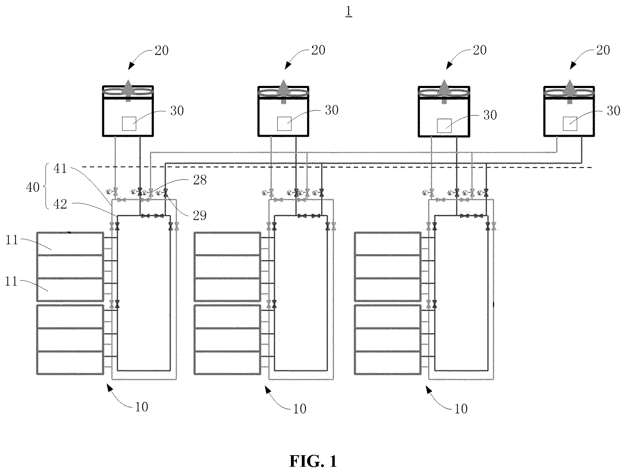

A refrigeration system 1 according to an embodiment of the present application will be described hereinafter with reference to FIGS. 1-7. The refrigeration system 1 according to the embodiment of the present application may be used to provide refrigeration to a data center, so that units of the data center can operate at an appropriate temperature.

As shown in FIG. 1, the refrigeration system 1 according to an embodiment of the present application includes an indoor heat exchange module 10 and an outdoor heat exchange module 20.

Specifically, the indoor heat exchange module 10 is used for refrigerant to absorb heat. The outdoor heat exchange module 20 is used for the refrigerant to dissipate heat. It is understood that the refrigerant in the indoor heat exchange module 10 exchanges heat with indoor air and absorb heat in the indoor air to reduce an indoor temperature, thereby achieving the purpose of cooling; the heated refrigerant dissipates heat in the outdoor heat exchange module 20, thereby dissipating heat of the refrigerant to the outdoor atmosphere; and then the cooled refrigerant flows back to the indoor heat exchange module 10. In this cycle, circulation flow of the refrigerant between the indoor heat exchange module 10 and the outdoor heat exchange module 20 is completed.

The outdoor heat exchange module 20 includes a compression device 20a, an evaporative condenser 24 and a liquid supplement device 30. The compression device 20a is used to compress a low-temperature and low-pressure gaseous refrigerant output from the indoor heat exchange module 10 into a high-temperature and high-pressure gaseous refrigerant. The high-temperature and high-pressure gaseous refrigerant is condensed in the evaporative condenser 24 to convert the refrigerant from a gas state to a liquid state. Then the liquid refrigerant flows back to an input terminal of the indoor heat exchange module 10, and the refrigerant absorbs heat in the indoor heat exchange module 10 and is converted from the liquid state to the gas state, and flows back to the compression device 20a. It is understood that the evaporative condenser 24 condenses the refrigerant through heat exchange between a cooling liquid and the refrigerant, so that the refrigerant dissipates heat and is converted from a gas state to a liquid state. The liquid supplement device 30 is used to provide the cooling liquid to the evaporative condenser 24 in a specific time period, and the cooling liquid may be water.

The outdoor heat exchange module 20 is switched between a standby mode and an active mode. Some of a plurality of outdoor heat exchange modules 20 are in the active mode, and the others are in the standby mode. In the standby mode, the outdoor heat exchange module 20 is disconnected from the indoor heat exchange module 10; when the outdoor heat exchange module 20 is switched to the active mode, the outdoor heat exchange module 20 is connected to the indoor heat exchange module 10. It is understood that the outdoor heat exchange module 20 in the active mode means that the outdoor heat exchange module 20 is currently used, that is, the refrigerant dissipates heat in the outdoor heat exchange module 20 and flows back to the indoor heat exchange module 10 to absorb heat; the outdoor heat exchange module 20 in the standby mode means that the outdoor heat exchange module 20 is currently unused, that is, the refrigerant does not dissipate heat in the outdoor heat exchange module 20 or the refrigerant after heat dissipation is not delivered to the indoor heat exchange module 10.

In an example, there are a plurality of outdoor heat exchange modules 20, wherein the number of outdoor heat exchange modules 20 in the active mode and the number of indoor heat exchange modules 10 are set in one-to-one correspondence, that is, multiple outdoor heat exchange modules 20 in the active mode are connected to multiple indoor heat exchange modules 10 in a one-to-one manner, so that the refrigerant circulates between the connected outdoor heat exchange module 20 and the indoor heat exchange module 10. The outdoor heat exchange module 20 in the standby mode may be connected with any one of the indoor heat exchange modules 10, so that when one outdoor heat exchange module 20 in the active mode fails, the outdoor heat exchange module 20 in the standby mode is switched to the active mode and is connected to the indoor heat exchange module 10 corresponding to the one outdoor heat exchange module 20 that has failed.

When the outdoor heat exchange module 20 is switched from the active mode to the standby mode, the evaporative condenser 24 and the compression device 20a of the outdoor heat exchange module 20 start up; and during the startup process of the compression device 20a, the cooling liquid of the evaporative condenser 24 is supplied by the liquid supplement device 30. The startup process of the compression device 20a refers to a time period from startup of a compressor to a normal operation, for example, the time required for preheating and self-checking after the compressor starts up. During this time period, the compression device 20a is not in an operation state.

It can be understood that when the outdoor heat exchange module 20 is switched to the active mode, i.e., at an initial start-up stage of the outdoor heat exchange module 20, the evaporative condenser 24 and the compression device 20a will take a certain startup time before they can enter a normal operation state, and thus the outdoor heat exchange module 20 does not have cooling capacity at the initial start-up stage. By setting the liquid supplement device 30 to provide the cooling liquid to the evaporative condenser 24 during the startup process of the compression device 20a, the gaseous refrigerant output by the indoor heat exchange module 10 can enter the evaporative condenser 24 without being compressed by the compression device 20a, and exchange heat with the cooling liquid to condense the refrigerant from a gas state to a liquid state. Then the liquid refrigerant is delivered to the indoor heat exchange module 10 for heat absorption. As a result, it is ensured that the outdoor heat exchange module 20 has a certain cooling capacity at the initial startup stage of the outdoor heat exchange module 20, which avoids insufficient cooling capacity caused by the startup process of the compression device 20a at the initial startup stage of the outdoor heat exchange module 20, thereby realizing continuous cooling of the refrigeration system 1 and then ensuring operation stability of the data center.

In an embodiment, the number of outdoor heat exchange modules 20 is greater than the number of indoor heat exchange modules 10. Among the plurality of outdoor heat exchange modules 20, the number of outdoor heat exchange modules 20 in the active mode is M, and the number of outdoor heat exchange modules 20 in the standby mode is N. The number of indoor heat exchange modules 10 is the same as the number M of outdoor heat exchange modules 20 in the active mode and is set in one-to-one correspondence. When M<6, N=1; when M ≥ 6, N=2. Therefore, when the number of indoor heat exchange modules 10 is large (for example, when M ≥ 6), two outdoor heat exchange modules 20 may be set as standbys, to meet cooling capacity requirements of the indoor heat exchange modules 10 corresponding to the outdoor heat exchange modules 20 that have failed when two or more of the outdoor heat exchange modules 20 in the active mode fail, thereby ensuring the cooling effect of the refrigeration system 1 on the data center.

In an example, as shown in FIG. 1, the number of outdoor heat exchange modules 20 may be four, wherein three outdoor heat exchange modules 20 are in the active mode, and the other outdoor heat exchange module 20 is in the standby mode. The number of indoor heat exchange modules 10 may be three and the three indoor heat exchange modules may be set in one-to-one correspondence with the three outdoor heat exchange modules 20 in the active mode. When switching to the active mode, the outdoor heat exchange module 20 in the standby mode may be connected with any one of the three indoor heat exchange modules 10.

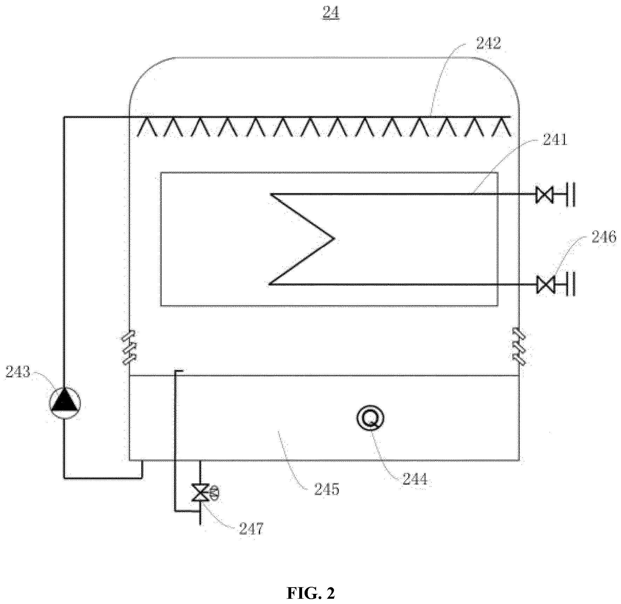

In an embodiment, as shown in FIG. 2, the evaporative condenser 24 includes a condensing coil 241, a spray device 242 and a liquid collecting tray 245.

Specifically, an input terminal of the condensing coil 241 is connected to the output terminal of the compression device 20a, and an output terminal of the condensing coil 241 is connected to the input terminal of the indoor heat exchange module 10. The spray device 242 is used to spray cooling liquid to the condensing coil 241, so that the refrigerant in the condensing coil 241 is converted from a liquid state to a gas state. The liquid collecting tray 245 is used to collect the cooling liquid output from the spray device 242. When the outdoor heat exchange module 20 is switched to the active mode, during the startup process of the compression device 20a, the spray device 242 is supplied with the cooling liquid from the liquid supplement device 30. After the compression device 20a is started normally, the spray device 242 is supplied with the cooling liquid from the liquid collecting tray 245 through a spray pump 243. Specifically, the cooling liquid flows out from an output terminal of the spray device 242 and is sprayed on the condensing coil 241; the sprayed water exchanges heat with the refrigerant in the condensing coil 241 and then falls into the liquid collecting tray 245; and the cooling liquid in the liquid collecting tray 245 is pumped to the input terminal of the spray device 242 through the spray pump 243 for circulation. The cooling liquid may be water, and the liquid collecting tray 245 may be a water collecting tray.

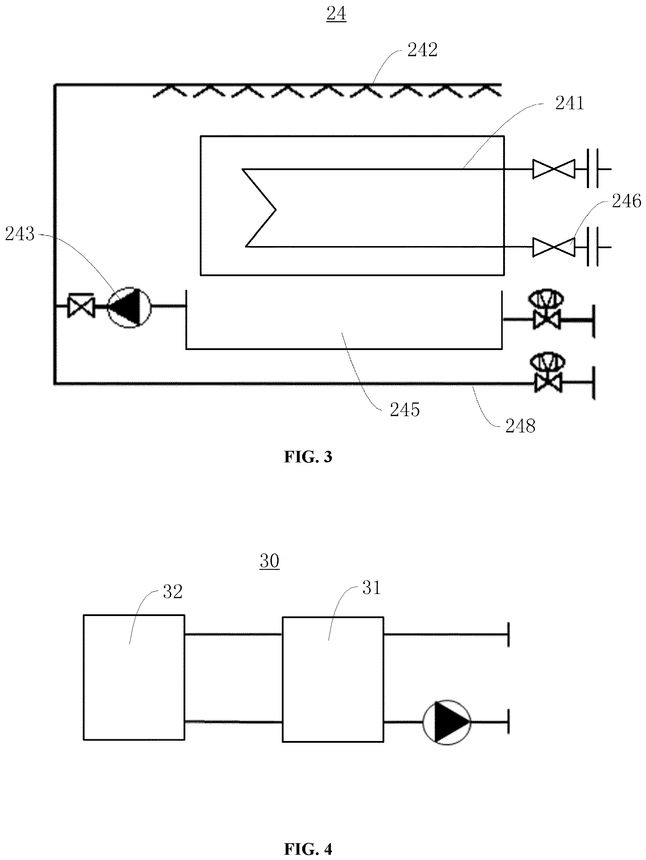

In a specific example, as shown in FIG. 2, the input and output terminals of the condensing coil 241 are respectively provided with a shut-off valve 246 for turning on or off the input and output terminals of the condensing coil 241, thereby controlling heat exchange time between the refrigerant in the condensing coil 241 and the cooling liquid. The evaporative condenser 24 further includes a water quality sensor 244 and a drain valve 247. The water quality sensor 244 is used to detect water quality of the cooling liquid input to the evaporative condenser 24. The drain valve 247 is used to control output of the cooling liquid in the evaporative condenser 24. Furthermore, as shown in FIG. 3, the evaporative condenser 24 further includes a water supplement pipe 248 connected to the spray device 242. The water supplement pipe 248 is used to connect the liquid supplement device 30. An on-off valve is provided in the water supplement pipe 248, and is used to switch on or off the water supplement pipe 248 to control the cooling liquid of the liquid supplement device 30 to be input to the spray device 242.

As shown in FIG. 4, the liquid supplement device 30 includes a liquid storage tank 31 and a refrigeration device 32. The liquid storage tank 31 is used to store cooling liquid. The refrigeration device 32 is used to provide cooling energy to the cooling liquid in the liquid storage tank 31. The cooling liquid may be water, and the liquid storage tank 31 may be a water storage tank. When the outdoor heat exchange module 20 is in the standby mode, the refrigeration device 32 operates to maintain the cooling liquid in the liquid storage tank 31 within a preset temperature range. Thus, it can be ensured that when the outdoor heat exchange module is switched to the active mode, the cooling liquid supplied by the liquid supplement device 30 meets temperature requirements for heat exchange with the refrigerant, thereby ensuring that the evaporative condenser 24 has ability to condense the refrigerant during the startup process of the compression device 20a, i.e., ensuring that the outdoor heat exchange module 20 has a certain cooling capacity at the initial startup stage.

In an example, the refrigeration device 32 may be a direct expansion air conditioning unit (DX A/C). It can be understood that the direct expansion air conditioning unit itself has its own compressor; and liquid refrigerant directly evaporates (expands) in an evaporator coil in a refrigeration system of the direct expansion air conditioning unit, thereby achieving cooling by absorbing heat from air (i.e., air inside an air-conditioning room) outside the coil. Further, the cooled air is used as a refrigerant to cool the cooling liquid in the liquid storage tank 31, thereby maintaining the cooling liquid in the liquid storage tank 31 within the certain temperature range. Optionally, when the outdoor heat exchange module 20 is in the standby mode, the direct expansion air conditioning unit is in a normal operation state, so that the cooling liquid in the liquid storage tank 31 is always kept within the preset temperature range.

In an embodiment, the compression device 20a includes an oil-free compressor 21. The oil-free compressor 21 is connected between the output terminal of the indoor heat exchange module 10 and the input terminal of the evaporative condenser 24. It should be noted that a cylinder of the oil-free compressor 21 does not contain lubricating oil. In this way, in the process of circulating the refrigerant between the indoor heat exchange module 10 and the outdoor heat exchange module 20, there is no need to consider the oil return problem of the compressor, thereby solving the technical problem that the compressor of the refrigeration system 1 in the related art is difficult to ensure the oil return effect due to a long flow path of the refrigerant, which affects the stability of the refrigeration system 1. Therefore, the refrigeration system 1 according to the embodiment of the present application adopts the oil-free compressor 21 without having to consider the oil return problem of the compressor, and has advantages such as stable operation and low equipment cost.

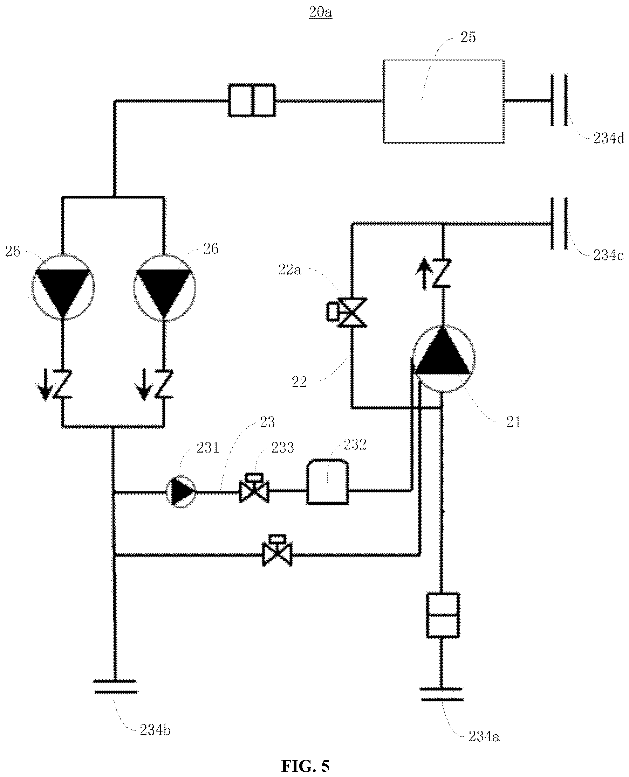

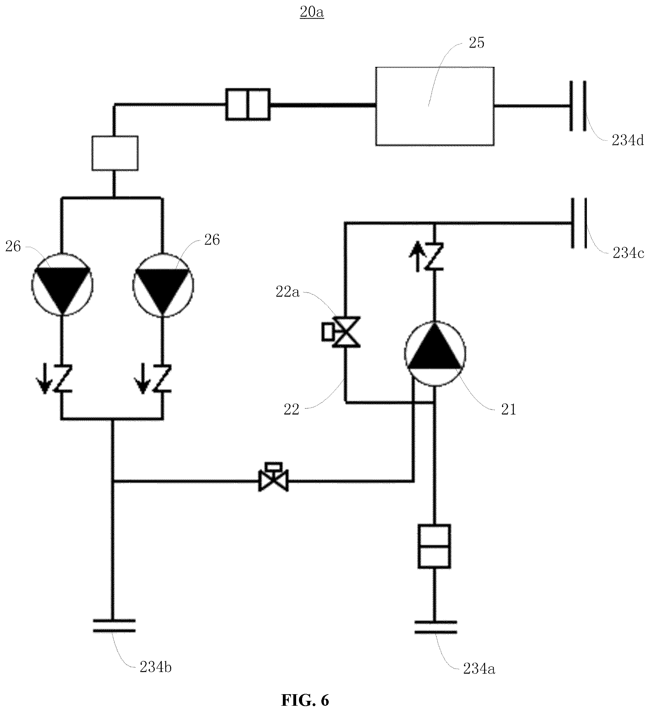

In an embodiment, as shown in FIG. 5 and FIG. 6, the compression device 20a further includes a direct flow pipeline 22 connected in parallel with the oil-free compressor 21. The direct flow pipeline 22 is connected between the output terminal of the indoor heat exchange module 10 and the input terminal of the evaporative condenser 24. When the outdoor heat exchange module 20 is switched to the active mode and during the startup process of the compression device 20a, the refrigerant is delivered from the output terminal of the indoor heat exchange module 10 to the input terminal of the evaporative condenser 24 through the direct flow pipeline 22. As a result, it can be ensured that during the startup process of the compression device 20a, the refrigerant can flow to the evaporative condenser 24 for condensation, so that the outdoor heat exchange module 20 has a cooling capacity at the initial startup stage.

In an example, as shown in FIG. 5 and FIG. 6, a direct flow valve 22a is further provided in the direct flow pipeline 22 for switching on or off the direct flow pipeline 22. When the outdoor heat exchange module 20 is switched to the active mode and during the startup process of the compression device 20a, the direct flow valve 22a is turned on, so that the gaseous refrigerant output by the indoor heat exchange module 10 is directly delivered to the input terminal of the evaporative condenser 24 without passing through the compression device 20a. After the compression device 20a is started normally, the direct flow valve 22a is turned off, so that the gaseous refrigerant output by the indoor heat exchange module 10 is compressed by the compression device 20a and then delivered to the input terminal of the evaporative condenser 24.

In various embodiments of the present application, the oil-free compressor 21 may be an air suspension compressor or a magnetic suspension compressor.

In an embodiment, as shown in FIG. 5, the oil-free compressor 21 may be an air suspension compressor.

Specifically, the compression device 20a further includes an air supply pipeline 23. The air supply pipeline 23 is connected to an output terminal of a liquid storage portion 25 and an input terminal of the air suspension compressor. When the outdoor heat exchange module 20 is in the standby mode, the air supply pipeline 23 converts the refrigerant output from the liquid storage portion 25 from a liquid state to a gas state, and delivers it to the input terminal of the air suspension compressor. It can be understood that in the outdoor heat exchange module 20 in the standby mode, the gaseous refrigerant continuously passes through the air suspension compressor through the air supply pipeline 23, so that bearings of the air suspension compressor are in a suspended state, thereby ensuring that the air suspension compressor can be in a continuous operation state. In this way, when the outdoor heat exchange module 20 is switched from the standby mode to the active mode, there is no need to wait for the startup process of the air suspension compressor, and the refrigerant can directly circulate between the outdoor heat exchange module 20 and the indoor heat exchange module 10, thereby ensuring heat exchange effects of the refrigerant in the outdoor heat exchange module 20 and the indoor heat exchange module 10.

Optionally, the outdoor heat exchange module 20 further includes a liquid storage portion 25. The liquid storage portion 25 is connected between the output terminal of the evaporative condenser 24 and the input terminal of the indoor heat exchange module 10, and is used to store the refrigerant output from the evaporative condenser 24. The air supply pipeline 23 includes a liquid supplement pump 231 and a liquid conversion portion 232. The liquid supplement pump 231 is connected to the output terminal of the liquid storage portion 25, and is used to pump the refrigerant in the liquid storage portion 25 to the gas conversion portion 232. The gas conversion portion 232 is connected to the input terminal of the air suspension compressor and is used to convert the refrigerant from a liquid state to a gas state.

In an embodiment, as shown in FIG. 5, the outdoor heat exchange module 20 further includes a liquid storage portion 25. The liquid storage portion 25 is connected between the output terminal of the evaporative condenser 24 and the input terminal of the indoor heat exchange module 10, and is used to store the refrigerant output from the evaporative condenser 24. The air supply pipeline 23 includes a liquid conversion portion, a liquid supplement pump 231 and a gas conversion portion 232 which are sequentially connected in a direction from an output terminal to an input terminal of the air suspension compressor. The liquid conversion portion is used to convert the refrigerant output by the air suspension compressor from a gas state to a liquid state, and deliver it to the liquid storage portion 25. The gas conversion portion 232 is connected between the liquid storage portion 25 and the input terminal of the gas suspension compressor, and is used to convert the refrigerant in the liquid storage portion 25 from a gas state to a liquid state. The liquid supplement pump 231 is connected between the liquid storage portion 25 and the gas conversion portion 232, and is used to pump the refrigerant in the liquid storage portion 25 to the gas conversion portion 232. Both the liquid supplement pump 231 and the air suspension compressor are powered by an uninterruptible power system (UPS), so that the air suspension compressor can run uninterruptedly when the outdoor heat exchange module 20 is in the standby mode. It is understood that the uninterruptible power system is an uninterruptible power system containing an energy storage device. When the mains input is normal, the uninterruptible power system will stabilize the mains and supply it to the load (i.e., the liquid supplement pump 231 and the air suspension compressor) for use. At this point, the uninterruptible power system is equivalent to an alternating current voltage stabilizer, and it also charges a battery therein. When the mains power is interrupted (accidental power failure), the uninterruptible power system will immediately continue to supply 220V alternating current power to the load by switching and converting the direct current power of the battery through an inverter, thereby enabling the load to maintain normal operation and protecting software and hardware of the load from being damaged. The uninterruptible power system usually provides protection against high voltage or low voltage.

In a specific example, as shown in FIG. 5, the compression device 20a includes a pump cabinet. The air suspension compressor, the liquid storage portion 25, and a part of the air supply pipeline 23 are provided in the pump cabinet. Specifically, the pump cabinet includes a gas refrigerant input terminal 234a, a liquid refrigerant output terminal 234b, a gas refrigerant output terminal 234c, and a liquid refrigerant input terminal 234d. The gas refrigerant input terminal 234a and the liquid refrigerant output terminal 234b are used to connect the output terminal and the input terminal of the indoor heat exchange module, respectively. The gas refrigerant output terminal 234c and the liquid refrigerant input terminal 234d are used to connect the input terminal and the output terminal of the evaporative condenser 24, respectively. The input terminal and the output terminal of the liquid conversion portion of the air supply pipeline 23 are also connected to the gas refrigerant output terminal 234c and the liquid refrigerant input terminal 234d, respectively, that is, the liquid conversion portion of the air supply pipeline 23 is arranged in parallel with the evaporative condenser 24.

In an embodiment, as shown in FIG. 5, the air supply pipeline 23 further includes a first on-off valve 233 for switching on-off the air supply pipeline 23, i.e., turning on or off the air circulation pipeline. For example, the first on-off valve 233 may be an electromagnetic valve and is provided between the liquid supplement pump 231 and the gas conversion portion 232. By controlling opening or closing of the first on-off valve 233, the liquid supplement pump 231 and the gas conversion portion 232 are connected or disconnected.

Further, a liquid pump 26 and a second on-off valve (not shown) are provided between the liquid storage portion 25 and the indoor heat exchange module 10. The liquid pump 26 is used to pump the refrigerant in the liquid storage portion 25 to the indoor heat exchange module 10, and the second on-off valve is used to switch on or off a refrigerant delivery pipe between the liquid storage portion 25 and the indoor heat exchange module 10. For example, the second on-off valve may be an electronic expansion valve 13 and is provided between the liquid pump 26 and the indoor heat exchange module 10. It can be understood that the electronic expansion valve 13 may use an electrical signal generated by adjusting parameters to control a voltage or current applied to the electronic expansion valve 13, thereby achieving the purpose of adjusting a flow rate of liquid refrigerant delivered by the liquid pump 26 to the indoor heat exchange module 10.

When the outdoor heat exchange module 20 is in the active mode, the first on-off valve 233 is turned off and the second on-off valve is turned on. As a result, the air supply pipeline 23 is tuned off, and the outdoor heat exchange module 20 is connected to the indoor heat exchange module 10, so that the refrigerant circulates through the air suspension compressor, the evaporative condenser 24 and the indoor heat exchange module 10 by the liquid pump 25. When the outdoor heat exchange module 20 is in the standby mode, the first on-off valve 233 is turned on and the second on-off valve is turned off. As a result, the outdoor heat exchange module 20 is disconnected from the indoor heat exchange module 10, and the air suspension compressor is connected to the air supply pipeline 23, and the liquid supplement pump 231 and the air suspension compressor are continuously powered by the uninterrupted power system. In this way, the refrigerant passing through the air suspension compressor circulates in the air supply pipeline 23, thereby ensuring continuous operation of the air suspension compressor.

In another embodiment, as shown in FIG. 6, the oil-free compressor 21 may be a magnetic suspension compressor. It is understood that the magnetic suspension compressor can be started under low frequency and low voltage, and thus a starting current is small and the interference to the power grid is small. Meanwhile, after starting, the magnetic suspension compressor quickly reaches a predetermined temperature which shortens the start-up process. Moreover, the magnetic suspension compressor runs at a lower speed under partial load for most of the time, thus the magnetic suspension compressor has less wear and has a longer service life.

In a specific example, as shown in FIG. 6, the compression device 20a includes a pump cabinet. The magnetic suspension compressor and the liquid storage portion 25 are provided in the pump cabinet. Specifically, the pump cabinet includes a gas refrigerant input terminal 234a, a liquid refrigerant output terminal 234b, a gas refrigerant output terminal 234c, and a liquid refrigerant input terminal 234d. The gas refrigerant input terminal 234a and the liquid refrigerant output terminal 234b are used to connect the output terminal and the input terminal of the indoor heat exchange module, respectively. The gas refrigerant output terminal 234c and the liquid refrigerant input terminal 234d are used to connect the input terminal and the output terminal of the evaporative condenser 24.

In an embodiment, the refrigeration system 1 further includes a refrigerant delivery pipe network 40, which is connected between the outdoor heat exchange module 20 and the indoor heat exchange module 10 and is used to deliver the refrigerant between the outdoor heat exchange module 20 and the indoor heat exchange module 10. In this way, by controlling the outdoor heat exchange module 20 to be connected to the refrigerant delivery pipe network 40 in the active mode or be disconnected from the refrigerant delivery pipe network 40 in the standby mode, it is realized that the outdoor heat exchange module 20 is connected to the indoor heat exchange module 10 in the active mode or is disconnected from the indoor heat exchange module 10 in the standby mode. As a result, the pipeline arrangement is convenient and it is convenient to switch the outdoor heat exchange module 20 between the active mode and the standby mode.

In an example, as shown in FIG. 1, there are a plurality of indoor heat exchange modules 10, and a plurality of refrigerant delivery pipe networks 40 are arranged in one-to-one correspondence with the plurality of indoor heat exchange modules 10. The outdoor heat exchange module 20 in the active mode is connected with the corresponding indoor heat exchange module 10 through the refrigerant delivery pipe network 40. The outdoor heat exchange module 20 in the standby mode may be connected to any one of the refrigerant delivery pipe networks 40 of the plurality of indoor heat exchange modules 10, so that when one outdoor heat exchange module 20 in the active mode fails, the outdoor heat exchange module 20 in the standby mode is switched to the active mode and is connected to the refrigerant delivery pipe network 40 of the corresponding indoor heat exchange module 10, thereby replacing the one outdoor heat exchange module 20 that has failed to maintain the cooling requirement of the indoor heat exchange module 10, and then ensuring the cooling effect of the refrigeration system 1.

Optionally, as shown in FIG. 1, the refrigerant delivery pipe network 40 includes a first delivery pipe network 41 and a second delivery pipe network 42. The output terminal of the outdoor heat exchange module 20 is connected with the input terminal of the indoor heat exchange module 10 through the first delivery pipe network 41. The output terminal of the indoor heat exchange module 10 is connected with the input terminal of the outdoor heat exchange module 20 through the second delivery pipe network 42. In an example, a first shut-off valve 411 is provided in the first delivery pipe network 41, and a second shut-off valve 421 is provided in the second delivery pipe network 42. It is understood that the first delivery pipe network 41 is used to deliver the liquid refrigerant output from the outdoor heat exchange module 20 to the indoor heat exchange module 10. After the liquid refrigerant absorbs heat and vaporizes in the indoor heat exchange module 10, the gaseous refrigerant is delivered to the outdoor heat exchange module 20 through the second delivery pipe network 42. The gaseous refrigerant is compressed and condensed in the outdoor heat exchange module 20 and then converted into a liquid refrigerant, and then is again delivered to the indoor heat exchange module 10 through the first delivery pipe network 41 for circulation.

Optionally, the outdoor heat exchange module 20 further includes a third on-off valve 28 and a fourth on-off valve 29. The third on-off valve 28 is provided between the output terminal of the outdoor heat exchange module 20 and the first delivery pipe network 41. The fourth on-off valve 29 is provided between the input terminal of the outdoor heat exchange module 20 and the second delivery pipe network 42. When the outdoor heat exchange module 20 is in the active mode, the third on-off valve 28 and the fourth on-off valve 29 are both tuned on. When the outdoor heat exchange module 20 is in the standby mode, the third on-off valve 28 and the fourth on-off valves 28 are both turned off. The third on-off valve 28 and the fourth on-off valve 29 may both be electromagnetic valves. Therefore, the connections between the outdoor heat exchange module 20 and the first delivery pipe network 41, and between the outdoor heat exchange module 20 and the second delivery pipe network 42, are relatively simple, and it is convenient to switch the outdoor heat exchange module 20 between the active mode and the standby mode.

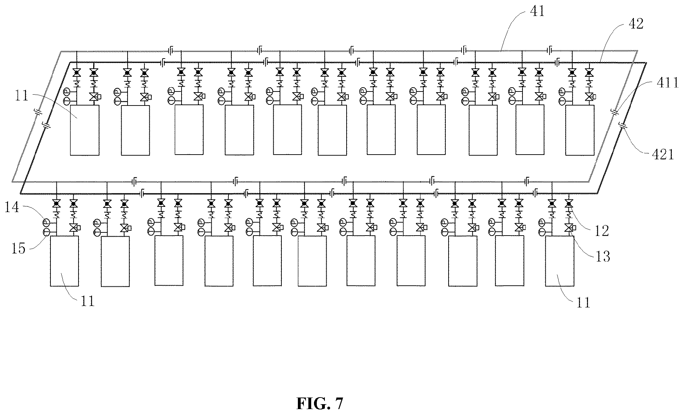

In an embodiment, as shown in FIG. 7, the indoor heat exchange module 10 includes a plurality of plate heat exchangers 11. Input terminals of the plurality of plate heat exchangers 11 are connected in parallel to the first delivery pipe network 41. Output terminals of the plurality of plate heat exchangers 11 are connected in parallel to the second delivery pipe network 42. In an example, the plate heat exchanger 11 may be installed on a side wall of a cabinet of the data center, thereby improving the cooling effect of the plate heat exchanger 11 on the cabinet. The plate heat exchanger 11 may be a typical copper tube aluminum fin heat exchanger, or may be a micro-channel heat exchanger in the field of vehicle air conditioning, which is not specifically limited in the embodiment of the present application. By providing a plurality of plate heat exchangers 11 in the indoor heat exchange module 10, a heat exchange area of the indoor heat exchange module 10 can be increased, thereby ensuring the cooling effect and cooling efficiency of the refrigeration system 1 for the data center.

In an example, a pressure sensor 14 and a temperature sensor 15 are provided in a pipeline connecting the input terminal of the plate heat exchanger 11 and the first delivery pipe network 41, to monitor pressure and temperature of the liquid refrigerant entering the input terminal of the plate heat exchanger 11. A shut-off ball valve 12 and an electronic expansion valve 13 are provided in a pipeline connecting the output terminal of the plate heat exchanger 11 and the second delivery pipe network 42, to turn on or off the pipeline connecting the output terminal of the plate heat exchanger 11 and the second delivery pipe network 42, and adjust a flow rate of gaseous refrigerant delivered to the second delivery pipe network 42.

Other components of the refrigeration system 1 of the foregoing embodiment may adopt various technical solutions known to those skilled in the art now and in the future, which will not be described in detail here.

By adopting the foregoing technical solution, in the refrigeration system according to the embodiment of the present application, the outdoor heat exchange module in the standby mode can be switch to the active mode when the outdoor heat exchange module in the active mode fails, thereby ensuring cooling supply of the indoor heat exchange module, improving operation stability of the refrigeration system and having a certain cooling capacity with the outdoor heat exchange module in its initial stage of switching to the standby mode.

According to the refrigeration system 1 of the embodiment of the present application, a plurality of outdoor heat exchange modules 20 that are switched between the active mode and the standby mode are provided, and some of the outdoor heat exchange modules 20 are in the active mode, and the others of the outdoor heat exchange modules 20 are in the standby mode, so that when the outdoor heat exchange module 20 in the active mode fails, the outdoor heat exchange module 20 in the standby mode is switched to the active mode, thereby ensuring cooling supply of the indoor heat exchange module 10 and improving operation stability of the refrigeration system 1. Furthermore, by setting the liquid supplement device 30 to provide the cooling liquid to the evaporative condenser 24 during the startup process of the compression device 20a, it is ensured that the outdoor heat exchange module 20 has a certain cooling capacity at the initial startup stage of the outdoor heat exchange module 20, which avoids insufficient cooling capacity caused by the startup process of the compression device 20a at the initial startup stage of the outdoor heat exchange module 20, thereby realizing continuous cooling of the refrigeration system 1 and then ensuring operation stability of the data center.

The above-mentioned embodiments are not to be construed as limiting the scope of the present application. It will be apparent to a person skilled in the art that various modifications, combinations, sub-combinations and substitutions are possible, depending on design requirements and other factors.

## Claims

1. A refrigeration system (1), comprising:
an indoor heat exchange module (10) configured for refrigerant to absorb heat; and
a plurality of outdoor heat exchange modules(20) configured for the refrigerant to dissipate heat, and each of the outdoor heat exchange modules (20) comprising a compression device (20a), an evaporative condenser (24) and a liquid supplement device (30); and
wherein the outdoor heat exchange modules (20) are switchable between a standby mode and an active mode; in the standby mode, the outdoor heat exchange module (20) is disconnected from the indoor heat exchange module (10); when the outdoor heat exchange module (20) is switched to the active mode, the outdoor heat exchange module (20) is connected to the indoor heat exchange module (10), the compression device (20a) starts up, and the liquid supplement device (30) supplies cooling liquid to the evaporative condenser (24) during an startup process of the compression device (20a);
wherein when the outdoor heat exchange module (20) is in the active mode, the compression device (20a) is used to compress a low-temperature and low-pressure gaseous refrigerant output from the indoor heat exchange module (10) into a high-temperature and high-pressure gaseous refrigerant; the high-temperature and high-pressure gaseous refrigerant is condensed in the evaporative condenser (24) to convert the refrigerant from a gas state to a liquid state; and then the liquid refrigerant flows back to an input terminal of the indoor heat exchange module (10), and the refrigerant absorbs heat in the indoor heat exchange module (10) and is converted from the liquid state to the gas state, and flows back to the compression device (20a);
wherein the liquid supplement device (30) comprises:
a liquid storage tank (31) configured to store cooling liquid; and
a refrigeration device (32) configured to provide cooling energy to the cooling liquid in the liquid storage tank; wherein when the outdoor heat exchange module (20) is in the standby mode, the refrigeration device operates to maintain the cooling liquid in the liquid storage tank within a preset temperature range.

2. The refrigeration system of claim 1, wherein the evaporative condenser (24) comprises:
a condensing coil (241), an input terminal of the condensing coil being connected to an output terminal of the compression device (20a), and an output terminal of the condensing coil being connected to an input terminal of the indoor heat exchange module (10);
a spray device (242) configured to spray cooling liquid to the condensing coil, so that the refrigerant in the condensing coil is converted from a liquid state to a gas state; and
a liquid collecting tray (245) configured to collect the cooling liquid output from the spray device; and
wherein when the outdoor heat exchange module (20) is switched to the active mode, during the startup process of the compression device (20a), the spray device is supplied with the cooling liquid from the liquid supplement device (30); and after the compression device (20a) starts up normally, the spray device is supplied with the cooling liquid from the liquid collecting tray through a spray pump (243).

3. The refrigeration system of claim 1 or 2, wherein the compression device (20a) comprises an oil-free compressor; and the oil-free compressor is connected between an output terminal of the indoor heat exchange module (10) and an input terminal of the evaporative condenser (24).

4. The refrigeration system of claim 3, wherein the compression device (20a) further comprises a direct flow pipeline (22) connected in parallel with the oil-free compressor; and the direct flow pipeline is connected between the output terminal of the indoor heat exchange module (10) and the input terminal of the evaporative condenser (24); and
wherein when the outdoor heat exchange module (20) is switched to the active mode, during the startup process of the compression device (20a), the refrigerant is delivered from the output terminal of the indoor heat exchange module (10) to the input terminal of the evaporative condenser (24) through the direct flow pipeline.

5. The refrigeration system of claim 3 or 4, wherein the oil-free compressor is a magnetic suspension compressor.

6. The refrigeration system of claim 3 or 4, wherein the outdoor heat exchange module (20) further comprises a liquid storage portion (25); and the liquid storage portion is connected between an output terminal of the evaporative condenser (24) and an input terminal of the indoor heat exchange module (10), and is configured to store the refrigerant output from the evaporative condenser (24);
wherein the oil-free compressor is an air suspension compressor; the compression device (20a) further comprises an air supply pipeline (23); and the air supply pipeline is connected to an output terminal of the liquid storage portion and an input terminal of the air suspension compressor; and wherein when the outdoor heat exchange module (20) is in the standby mode, the air supply pipeline converts the refrigerant output from the liquid storage portion from a liquid state to a gas state, and delivers the refrigerant to the input terminal of the air suspension compressor.

7. The refrigeration system of claim 6, wherein the air supply pipeline comprises (23) a liquid supplement pump (231) and a gas conversion portion (232); the liquid supplement pump is connected to the output terminal of the liquid storage portion and is configured to pump the refrigerant in the liquid storage portion to the gas conversion portion; and the gas conversion portion is connected to the input terminal of the gas suspension compressor, and is configured to convert the refrigerant from a liquid state to a gas state.

8. The refrigeration system of any one of claims 1 to 7, further comprising:
a refrigerant delivery pipe network (40), which is connected between the outdoor heat exchange module (20) and the indoor heat exchange module (10) and is configured to deliver the refrigerant between the outdoor heat exchange module (20) and the indoor heat exchange module (10).

9. The refrigeration system of claim 8, wherein the refrigerant delivery pipe network comprises a first delivery pipe network (41) and a second delivery pipe network (42); an output terminal of the outdoor heat exchange module (20) is connected with an input terminal of the indoor heat exchange module (10) through the first delivery pipe network; and an output terminal of the indoor heat exchange module (10) is connected with an input terminal of the outdoor heat exchange module (20) through the second delivery pipe network.

10. The refrigeration system of claim 9, wherein the outdoor heat exchange module (20) further comprises a third on-off valve (28) and a fourth on-off valve (29); the third on-off valve is provided between the output terminal of the outdoor heat exchange module (20) and the first delivery pipe network; and the fourth on-off valve is provided between the input terminal of the outdoor heat exchange module (20) and the second delivery pipe network; and
wherein when the outdoor heat exchange module (20) is in the active mode, the third on-off valve and the fourth on-off valve are both tuned on; and when the outdoor heat exchange module (20) is in the standby mode, the third on-off valve and the fourth on-off valves are both turned off.

11. The refrigeration system of claim 9 or 10, wherein the indoor heat exchange module (10) comprises a plurality of plate heat exchangers (11); input terminals of the plurality of plate heat exchangers are connected in parallel to the first delivery pipe network; and output terminals of the plurality of plate heat exchangers are connected in parallel to the second delivery pipe network.

12. The refrigeration system of any one of claims 1 to 11, wherein the number of outdoor heat exchange modules (20) is greater than the number of indoor heat exchange modules (10); among the outdoor heat exchange modules (20), the number of outdoor heat exchange modules (20) in the active mode is M, and the number of outdoor heat exchange modules (20) in the standby mode is N;
wherein, when M<6, N=1; when M ≥6, N=2.

## Patentansprüche

1. Kühlsystem (1), umfassend:
ein Wärmeaustauschmodul für den Innenbereich (10), das so konfiguriert ist, dass ein Kältemittel Wärme absorbiert; und
eine Vielzahl von Wärmeaustauschmodulen für den Außenbereich (20), die so konfiguriert sind, dass das Kältemittel Wärme ableitet, und wobei jedes der Wärmeaustauschmodule für den Außenbereich (20) eine Kompressionsvorrichtung (20a), einen Verdampfungskondensator (24) und eine Flüssigkeitsergänzungsvorrichtung (30); und
wobei die Wärmeaustauschmodule für den Außenbereich (20) zwischen einem Standby-Modus und einem aktiven Modus umschaltbar sind; das Wärmeaustauschmodul für den Außenbereich (20) im Standby-Modus von dem Wärmeaustauschmodul für den Innenbereich (10) getrennt ist; wenn das Wärmeaustauschmodul für den Außenbereich (20) in den aktiven Modus geschaltet ist, das Wärmeaustauschmodul für den Außenbereich (20) mit dem Wärmeaustauschmodul für den Innenbereich (10) verbunden ist, die Kompressionsvorrichtung (20a) hochfährt und die Flüssigkeitsergänzungsvorrichtung (30) den Verdampfungskondensator (24) während eines Startvorgangs der Kompressionsvorrichtung (20a) mit Kühlflüssigkeit versorgt;
wobei, wenn das Wärmeaustauschmodul für den Außenbereich (20) sich im aktiven Modus befindet, die Kompressionsvorrichtung (20a) verwendet wird, um ein gasförmiges Kältemittel mit niedriger Temperatur und niedrigem Druck, das von dem Wärmeaustauschmodul für den Innenbereich (10) ausgegeben wird, in ein gasförmiges Kältemittel mit hoher Temperatur und hohem Druck zu komprimieren; das gasförmige Kältemittel mit hoher Temperatur und hohem Druck im Verdampfungskondensator (24) kondensiert wird, um das Kältemittel von einem gasförmigen Zustand in einen flüssigen Zustand umzuwandeln; und dann das flüssige Kältemittel zurück zu einem Eingangsanschluss des Wärmeaustauschmoduls für den Innenbereich (10) fließt, und das Kältemittel Wärme in dem Wärmeaustauschmodul für den Innenbereich (10) absorbiert und vom flüssigen Zustand in den gasförmigen Zustand umgewandelt wird und zurück zu der Kompressionsvorrichtung (20a) fließt;
wobei die Flüssigkeitsergänzungsvorrichtung (30) umfasst:
einen Flüssigkeitsspeichertank (31), der dazu konfiguriert ist, Kühlflüssigkeit zu speichern; und
eine Kühlvorrichtung (32), die dazu konfiguriert ist, der Kühlflüssigkeit in dem Flüssigkeitsspeichertank Kühlenergie bereitzustellen; wobei, wenn sich das Wärmeaustauschmodul für den Außenbereich (20) im Standby-Modus befindet, die Kühlvorrichtung arbeitet, um die Kühlflüssigkeit in dem Flüssigkeitsspeichertank innerhalb eines voreingestellten Temperaturbereichs zu halten.

2. Kühlsystem nach Anspruch 1, wobei der Verdampfungskondensator (24) umfasst:
eine Verflüssigerschlange (241), einen Eingangsanschluss der Verflüssigerschlange, der mit einem Ausgangsanschluss der Kompressionsvorrichtung (20a) verbunden ist, und einen Ausgangsanschluss der Verflüssigerschlange, der mit einem Eingangsanschluss des Wärmeaustauschmoduls für den Innenbereich (10) verbunden ist;
eine Sprühvorrichtung (242), die dazu konfiguriert ist, Kühlflüssigkeit auf die Verflüssigerschlange zu sprühen, so dass das Kältemittel in der Verflüssigerschlange von einem flüssigen Zustand in einen gasförmigen Zustand umgewandelt wird; und
eine Flüssigkeitsauffangschale (245), die dazu konfiguriert ist, die Kühlflüssigkeit, die von der Sprühvorrichtung ausgegeben wird, aufzufangen; und
wobei, wenn das Wärmeaustauschmodul für den Außenbereich (20) während des Startvorgangs der Kompressionsvorrichtung (20a) in den aktiven Modus geschaltet ist, die Sprühvorrichtung mit der Kühlflüssigkeit von der Flüssigkeitsergänzungsvorrichtung (30) versorgt wird; und nachdem die Kompressionsvorrichtung (20a) normal hochgefahren ist, die Sprühvorrichtung mit der Kühlflüssigkeit von der Flüssigkeitsauffangschale durch eine Sprühpumpe (243) versorgt wird.

3. Kühlsystem nach Anspruch 1 oder 2, wobei die Kompressionsvorrichtung (20a) einen ölfreien Kompressor umfasst; und der ölfreie Kompressor zwischen einem Ausgangsanschluss des Wärmeaustauschmoduls für den Innenbereich (10) und einem Eingangsanschluss des Verdampfungskondensators (24) verbunden ist.

4. Kühlsystem nach Anspruch 3, wobei die Kompressionsvorrichtung (20a) ferner eine Direktflussrohrleitung (22) umfasst, die parallel mit dem ölfreien Kompressor verbunden ist; und die Direktflussrohrleitung zwischen dem Ausgangsanschluss des Wärmeaustauschmoduls für den Innenbereich (10) und dem Eingangsanschluss des Verdampfungskondensators (24) verbunden ist; und
wobei, wenn das Wärmeaustauschmodul für den Außenbereich (20) während des Startvorgangs der Kompressionsvorrichtung (20a) in den aktiven Modus geschaltet ist, das Kältemittel von dem Ausgangsanschluss des Wärmeaustauschmoduls für den Innenbereich (10) zu dem Eingangsanschluss des Verdampfungskondensators (24) durch die Direktflussrohrleitung zugeführt wird.

5. Kühlsystem nach Anspruch 3 oder 4, wobei der ölfreie Kompressor ein Kompressor mit magnetischer Aufhängung ist.

6. Kühlsystem nach Anspruch 3 oder 4, wobei das Wärmeaustauschmodul für den Außenbereich (20) ferner einen Flüssigkeitsspeicherabschnitt (25) umfasst; und der Flüssigkeitsspeicherabschnitt zwischen einen Ausgangsanschluss des Verdampfungskondensators (24) und einen Eingangsanschluss des Wärmeaustauschmoduls für den Innenbereich (10) geschaltet ist und dazu konfiguriert ist, das Kältemitteln, das von dem Verdampfungskondensator (24) ausgegeben wird, zu speichern;
wobei der ölfreie Kompressor ein Luftfederungskompressor ist; die Kompressionsvorrichtung (20a) ferner eine Luftversorgungsleitung (23) umfasst; und die Luftversorgungsleitung mit einem Ausgangsanschluss des Flüssigkeitsspeicherabschnitts und einem Eingangsanschluss des Luftfederungskompressors verbunden ist; und wobei, wenn sich das Wärmeaustauschmodul für den Außenbereich (20) im Standby-Modus befindet, die Luftversorgungsleitung das Kältemittel, das von dem Flüssigkeitsspeicherabschnitt ausgegeben wird, von einem flüssigen Zustand in einen gasförmigen Zustand umwandelt und das Kältemittel dem Eingangsanschluss des Luftfederungskompressors zuführt.

7. Kühlsystem nach Anspruch 6, wobei die Luftversorgungsleitung (23) eine Flüssigkeitsergänzungspumpe (231) und einen Gasumwandlungsabschnitt (232) umfasst; die Flüssigkeitsergänzungspumpe mit dem Ausgangsanschluss des Flüssigkeitsspeicherabschnitts verbunden ist und dazu konfiguriert ist, das Kältemittel in dem Flüssigkeitsspeicherabschnitt zu dem Gasumwandlungsabschnitt zu pumpen; und der Gasumwandlungsabschnitt mit dem Eingangsanschluss des Gasfederungskompressors verbunden ist und dazu konfiguriert ist, das Kältemittel von einem flüssigen Zustand in einen gasförmigen Zustand umzuwandeln.

8. Kühlsystem nach einem der Ansprüche 1 bis 7, ferner umfassend:
ein Kältemittel-Zufuhrrohrnetz (40), das zwischen dem Wärmeaustauschmodul für den Außenbereich (20) und dem Wärmeaustauschmodul für den Innenbereich (10) verbunden ist und dazu konfiguriert ist, das Kältemittel zwischen dem Wärmeaustauschmodul für den Außenbereich (20) und dem Wärmeaustauschmodul für den Innenbereich (10) zuzuführen.

9. Kühlsystem nach Anspruch 8, wobei das Kältemittel-Zufuhrrohrnetz ein erstes Zufuhrrohrnetz (41) und ein zweites Zufuhrrohrnetz (42) umfasst; ein Ausgangsanschluss des Wärmeaustauschmoduls für den Außenbereich (20) mit einem Eingangsanschluss des Wärmeaustauschmoduls für den Innenbereich (10) durch das erste Zufuhrrohrnetz verbunden ist; und ein Ausgangsanschluss des Wärmeaustauschmoduls für den Innenbereich (10) mit einem Eingangsanschluss des Wärmeaustauschmoduls für den Außenbereich (20) durch das zweite Zufuhrrohrnetz verbunden ist.

10. Kühlsystem nach Anspruch 9, wobei das Wärmetauschmodul für den Außenbereich (20) ferner ein drittes Ein-/Aus-Ventil (28) und ein viertes Ein-/Aus-Ventil (29) umfasst; das dritte Ein-/Aus-Ventil zwischen dem Ausgangsanschluss des Wärmeaustauschmoduls für den Außenbereich (20) und dem ersten Zufuhrrohrnetz vorgesehen ist; und das vierte Ein-/Aus-Ventil zwischen dem Eingangsanschluss des Wärmeaustauschmoduls für den Außenbereich (20) und dem zweiten Zufuhrrohrnetz vorgesehen ist; und
wobei, wenn sich das Wärmeaustauschmodul für den Außenbereich (20) im aktiven Modus befindet, das dritte Ein-/Aus-Ventil und das vierte Ein-/Aus-Ventil beide eingeschaltet sind; und wenn sich das Wärmeaustauschmodul für den Außenbereich (20) im Standby-Modus befindet, das dritte Ein-/Aus-Ventil und das vierte Ein-/Aus-Ventil beide ausgeschaltet sind.

11. Kühlsystem nach Anspruch 9 oder 10, wobei das Wärmeaustauschmodul für den Innenbereich (10) eine Vielzahl von Plattenwärmeaustauschern (11) umfasst; Eingangsanschlüsse der Vielzahl von Plattenwärmeaustauschern parallel mit dem ersten Zufuhrrohrnetz verbunden sind; und Ausgangsanschlüsse der Vielzahl von Plattenwärmeaustauschern parallel mit dem zweiten Zufuhrrohrnetz verbunden sind.

12. Kühlsystem nach einem der Ansprüche 1 bis 11, wobei die Anzahl der Wärmeaustauschmodule für den Außenbereich (20) größer ist als die Anzahl der Wärmeaustauschmodule für den Innenbereich (10); unter den Wärmeaustauschmodulen für den Außenbereich (20) die Anzahl der Wärmeaustauschmodule für den Außenbereich (20) im aktiven Modus M ist und die Anzahl der Wärmeaustauschmodule für den Außenbereich (20) im Standby-Modus N ist;
Wobei, wenn M<6, N=1; wenn M≥6, N=2.

## Revendications

1. Système de réfrigération (1), comprenant :
un module d'échange de chaleur intérieur (10) configuré pour qu'un réfrigérant absorbe de la chaleur ; et
une pluralité de modules d'échange de chaleur extérieurs (20) configurés pour que le réfrigérant dissipe de la chaleur, et chacun des modules d'échange de chaleur extérieurs (20) comprenant un dispositif de compression (20a), un condenseur évaporatif (24) et un dispositif d'apport de liquide (30) ; et
dans lequel les modules d'échange de chaleur extérieurs (20) peuvent alterner entre un mode attente et un mode actif ; dans le mode attente, le module d'échange de chaleur extérieur (20) est séparé du module d'échange de chaleur intérieur (10); lorsque le module d'échange de chaleur extérieur (20) passe au mode actif, le module d'échange de chaleur extérieur (20) est relié au module d'échange de chaleur intérieur (10), le dispositif de compression (20a) démarre, et le dispositif d'apport de liquide (30) alimente en liquide de refroidissement le condenseur évaporatif (24) durant un procédé de démarrage du dispositif de compression (20a) ;
dans lequel lorsque le module d'échange de chaleur extérieur (20) est dans le mode actif, le dispositif de compression (20a) est utilisé pour comprimer un réfrigérant gazeux basse température et basse pression sorti du module d'échange de chaleur intérieur (10) en un réfrigérant gazeux haute température et haute pression ; le réfrigérant gazeux haute température et haute pression est condensé dans le condenseur évaporatif (24) pour convertir le réfrigérant d'un état gazeux à un état liquide ; et ensuite le réfrigérant liquide reflue vers une borne d'entrée du module d'échange de chaleur intérieur (10), et le réfrigérant absorbe de la chaleur dans le module d'échange de chaleur intérieur (10) et est converti de l'état liquide à l'état gazeux, et reflue vers le dispositif de compression (20a) ;
dans lequel le dispositif d'apport de liquide (30) comprend :
un réservoir de stockage de liquide (31) configuré pour stocker du liquide de refroidissement ; et
un dispositif de réfrigération (32) configuré pour fournir de l'énergie de refroidissement au liquide de refroidissement dans le réservoir de stockage de liquide ; dans lequel lorsque le module d'échange de chaleur extérieur (20) est dans le mode attente, le dispositif de réfrigération fonctionne pour maintenir le liquide de refroidissement dans le réservoir de stockage de liquide dans une plage de températures prédéfinie.

2. Système de réfrigération selon la revendication 1, dans lequel le condenseur évaporatif (24) comprend :
une bobine de condensation (241), une borne d'entrée de la bobine de condensation étant reliée à une borne de sortie du dispositif de compression (20a), et une borne de sortie de la bobine de condensation étant reliée à une borne d'entrée du module d'échange de chaleur intérieur (10) ;
un dispositif de pulvérisation (242) configuré pour pulvériser du liquide de refroidissement sur la bobine de condensation, de façon à ce que le réfrigérant dans la bobine de condensation soit converti d'un état liquide à un état gazeux; et
un plateau de collecte de liquide (245) configuré pour collecter le liquide de refroidissement sorti du dispositif de pulvérisation ; et
dans lequel lorsque le module d'échange de chaleur extérieur (20) passe au mode actif, durant le procédé de démarrage du dispositif de compression (20a), le dispositif de pulvérisation est alimenté en liquide de refroidissement à partir du dispositif d'apport de liquide (30) ; et après que le dispositif de compression (20a) a démarré normalement, le dispositif de pulvérisation est alimenté en liquide de refroidissement à partir du plateau de collecte de liquide par l'intermédiaire d'une pompe de pulvérisation (243).

3. Système de réfrigération selon la revendication 1 ou 2, dans lequel le dispositif de compression (20a) comprend un compresseur sans huile ; et le compresseur sans huile est relié entre une borne de sortie du module d'échange de chaleur intérieur (10) et une borne d'entrée du condenseur évaporatif (24).

4. Système de réfrigération selon la revendication 3, dans lequel le dispositif de compression (20a) comprend en outre une conduite d'écoulement direct (22) reliée en parallèle au compresseur sans huile ; et la conduite d'écoulement direct est reliée entre la borne de sortie du module d'échange de chaleur intérieur (10) et la borne d'entrée du condenseur évaporatif (24) ; et
dans lequel lorsque le module d'échange de chaleur extérieur (20) passe au mode actif, durant le procédé de démarrage du dispositif de compression (20a), le réfrigérant est distribué à partir de la borne de sortie du module d'échange de chaleur intérieur (10) jusqu'à la borne d'entrée du condenseur évaporatif (24) par l'intermédiaire de la conduite d'écoulement direct.

5. Système de réfrigération selon la revendication 3 ou 4, dans lequel le compresseur sans huile est un compresseur à suspension magnétique.

6. Système de réfrigération selon la revendication 3 ou 4, dans lequel le module d'échange de chaleur extérieur (20) comprend en outre une partie de stockage de liquide (25) ; et la partie de stockage de liquide est reliée entre une borne de sortie du condenseur évaporatif (24) et une borne d'entrée du module d'échange de chaleur intérieur (10), et est configurée pour stocker le réfrigérant sorti du condenseur évaporatif (24) ;
dans lequel le compresseur sans huile est un compresseur à suspension pneumatique ; le dispositif de compression (20a) comprend en outre une conduite d'alimentation en air (23) ; et la conduite d'alimentation en air est reliée à une borne de sortie de la partie de stockage de liquide et une borne d'entrée du compresseur à suspension pneumatique ; et dans lequel lorsque le module d'échange de chaleur extérieur (20) est dans le mode attente, la conduite d'alimentation en air convertit le réfrigérant sorti de la partie de stockage de liquide d'un état liquide à un état gazeux, et distribue le réfrigérant jusqu'à la borne d'entrée du compresseur à suspension pneumatique.

7. Système de réfrigération selon la revendication 6, dans lequel la conduite d'alimentation en air (23) comprend une pompe d'apport de liquide (231) et une partie de conversion de gaz (232) ; la pompe d'apport de liquide est reliée à la borne de sortie de la partie de stockage de liquide et est configurée pour pomper le réfrigérant dans la partie de stockage de liquide vers la partie de conversion de gaz ; et la partie de conversion de gaz est reliée à la borne d'entrée du compresseur à suspension gazeuse, et est configurée pour convertir le réfrigérant d'un état liquide à un état gazeux.

8. Système de réfrigération selon l'une quelconque des revendications 1 à 7, comprenant en outre :
un réseau de tuyaux de distribution de réfrigérant (40), qui est relié entre le module d'échange de chaleur extérieur (20) et le module d'échange de chaleur intérieur (10) et est configuré pour distribuer le réfrigérant entre le module d'échange de chaleur extérieur (20) et le module d'échange de chaleur intérieur (10).

9. Système de réfrigération selon la revendication 8, dans lequel le réseau de tuyaux de distribution de réfrigérant comprend un premier réseau de tuyaux de distribution (41) et un deuxième réseau de tuyaux de distribution (42) ; une borne de sortie du module d'échange de chaleur extérieur (20) est reliée à une borne d'entrée du module d'échange de chaleur intérieur (10) par l'intermédiaire du premier réseau de tuyaux de distribution ; et une borne de sortie du module d'échange de chaleur intérieur (10) est reliée à une borne d'entrée du module d'échange de chaleur extérieur (20) par l'intermédiaire du deuxième réseau de tuyaux de distribution.

10. Système de réfrigération selon la revendication 9, dans lequel le module d'échange de chaleur extérieur (20) comprend en outre une troisième vanne tout ou rien (28) et une quatrième vanne tout ou rien (29) ; la troisième vanne tout ou rien est fournie entre la borne de sortie du module d'échange de chaleur extérieur (20) et le premier réseau de tuyaux de distribution ; et la quatrième vanne tout ou rien est fournie entre la borne d'entrée du module d'échange de chaleur extérieur (20) et le deuxième réseau de tuyaux de distribution ; et
dans lequel lorsque le module d'échange de chaleur extérieur (20) est dans le mode actif, la troisième vanne tout ou rien et la quatrième vanne tout ou rien sont toutes les deux ouvertes ; et lorsque le module d'échange de chaleur extérieur (20) est dans le mode attente, la troisième vanne tout ou rien et la quatrième vanne tout ou rien sont toutes les deux fermées.

11. Système de réfrigération selon la revendication 9 ou 10, dans lequel le module d'échange de chaleur intérieur (10) comprend une pluralité d'échangeurs de chaleur à plaques (11) ; des bornes d'entrée de la pluralité d'échangeurs de chaleur à plaques sont reliées en parallèle au premier réseau de tuyaux de distribution ; et des bornes de sortie de la pluralité d'échangeurs de chaleur à plaques sont reliées en parallèle au deuxième réseau de tuyaux de distribution.

12. Système de réfrigération selon l'une quelconque des revendications 1 à 11, dans lequel le nombre de modules d'échange de chaleur extérieurs (20) est plus grand que le nombre de modules d'échange de chaleur intérieurs (10) ; parmi les modules d'échange de chaleur extérieurs (20), le nombre de modules d'échange de chaleur extérieurs (20) dans le mode actif est M, et le nombre de modules d'échange de chaleur extérieurs (20) dans le mode attente est N ;
dans lequel, lorsque M < 6, N = 1; lorsque M ≥ 6, N = 2.
